(19) Europäisches Patentamt
European Patent Office
Office européen des brevets

(11) **EP 4 209 975 A1**

(12) **EUROPEAN PATENT APPLICATION**

(43) Date of publication:
**12.07.2023 Bulletin 2023/28**

(21) Application number: **23151048.8**

(22) Date of filing: **11.01.2023**

(51) International Patent Classification (IPC):
***G06Q 10/04*** (2023.01)          ***G06Q 50/04*** (2012.01)

(52) Cooperative Patent Classification (CPC):
**G06Q 10/04; G06Q 50/04**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(30) Priority: **11.01.2022  CN 202210026540**

(71) Applicant: **Nio Technology (Anhui) Co., Ltd
Hefei City, Anhui 230601 (CN)**

(72) Inventors:
- **PENG, Yuanfeng
  Hefei City, Anhui 230601 (CN)**
- **YU, Miao
  Hefei City, Anhui 230601 (CN)**
- **LIU, Xiaohui
  Hefei City, Anhui 230601 (CN)**
- **MENG, Dahai
  Hefei City, Anhui 230601 (CN)**

(74) Representative: **Vossius & Partner
Patentanwälte Rechtsanwälte mbB
Siebertstraße 3
81675 München (DE)**

(54) **CARBON FOOTPRINT ESTIMATION METHOD AND SYSTEM FOR VEHICLE**

(57)    The disclosure provides a carbon footprint estimation method and system for a vehicle. The method includes the following steps: S100: establishing a carbon footprint model of the vehicle; S200: dividing the carbon footprint model into a first module and a second module, wherein a carbon footprint of the first module can be obtained from a database, and a carbon footprint of the second module cannot be obtained from the database; and S300: estimating, based on the carbon footprint model, the carbon footprints of the first module and the second module in a production stage; where step S300 includes the following sub-steps: S301: obtaining the carbon footprint of the first module in the production stage from the database; and S302: estimating, based on dimension parameters and materials of the second module, the carbon footprint of the second module in the production stage. By modularly calculating the carbon footprint of the vehicle in the production stage based on the carbon footprint model, the carbon footprint may be comprehensively controlled in a research and development stage.

FIG. 1

## Description

## Technical Field

The disclosure relates to a carbon footprint estimation method for a vehicle and a carbon footprint estimation system for implementing the method.

## Background Art

At present, the research on carbon emission reduction of passenger vehicles mainly focuses on calculating the carbon footprint of the whole life cycle of vehicles, which includes raw material obtaining, vehicle production, energy production and use, repair and maintenance stage and even disposal treatment. However, the existing carbon footprint calculation methods based on manufactured vehicles are difficult to propose a targeted guidance for vehicle design, because once vehicles enter a mass production stage, measures for reducing the carbon footprint of the whole life cycle are very limited. Therefore, it is necessary to comprehensively control the carbon emissions of the vehicle in a research and development stage of the vehicle.

## Summary of the Disclosure

According to different aspects, an object of the disclosure is to provide a method and system for quickly estimating a carbon footprint of a vehicle in a research and development stage.

In addition, the disclosure also aims to solve or alleviate other technical problems existing in the prior art.

The disclosure provides a carbon footprint estimation method to solve the above problems, specifically, including the following steps:

> S100: establishing a carbon footprint model of the vehicle;
> S200: dividing the carbon footprint model into a first module and a second module, wherein a carbon footprint of the first module can be obtained from a database, and a carbon footprint of the second module cannot be obtained from the database; and
> S300: estimating, based on the carbon footprint model, the carbon footprints of the first module and the second module in a production stage;
> where step S300 includes the following sub-steps:

>> S301: obtaining the carbon footprint of the first module in the production stage from the database; and
>> S302: estimating, based on dimension parameters and materials of the second module, the carbon footprint of the second module in the production stage.

According to the carbon footprint estimation method provided in an aspect of the disclosure, the first module includes a traction battery system, an electric drive system and a seat system, and/or the second module includes a body-in-white system and a chassis system.

According to the carbon footprint estimation method provided in an aspect of the disclosure, in step S302, depending on materials of the body-in-white system, a carbon footprint of the body-in-white system in the production stage is estimated based on an average bulk density of the body-in-white system and a theoretical volume enclosed by the body-in-white system.

According to the carbon footprint estimation method provided in an aspect of the disclosure, the average bulk density depends on a vehicle model and a ratio of materials for manufacturing the body-in-white system.

According to the carbon footprint estimation method provided in an aspect of the disclosure, in step S302, the body-in-white system is divided based on a front axle and a rear axle of the carbon footprint model, and the theoretical volume enclosed by the body-in-white system is estimated in modules.

According to the carbon footprint estimation method provided in an aspect of the disclosure, the body-in-white system is divided into a plurality of cubes based on the front axle and the rear axle of the carbon footprint model, and theoretical volumes of the cubes are calculated respectively.

According to the carbon footprint estimation method provided in an aspect of the disclosure, in step S302, a carbon footprint of the chassis system in the production stage is estimated based on a wheelbase of the carbon footprint model.

According to the carbon footprint estimation method provided in an aspect of the disclosure, in step S301, a carbon footprint of the traction battery system in the production stage is obtained from the database based on materials, energy density and mass of the traction battery system in the carbon footprint model.

According to the carbon footprint estimation method provided in an aspect of the disclosure, the second module further includes an accessory system, including interior trim parts, and a carbon footprint of the accessory system in the production stage is estimated according to the dimension parameters of the second module.

According to another aspect of the disclosure, the disclosure provides a carbon footprint estimation system that can be configured to implement the above method, including:

> an input device, configured to input vehicle parameters;
> a model generation device, connected to the input device and configured to establish a carbon footprint model based on the input vehicle parameters, where the carbon footprint model includes a first module and a second module, a carbon footprint of the first module can be obtained from a database, and a carbon footprint of the second module cannot be obtained from the database;

a memory, storing the carbon footprint of the first module in a production stage; and

an estimation device, connected to the memory and configured to obtain, from the memory, the carbon footprint of the first module in the production stage and to estimate, based on dimension parameters and materials of the second module, the carbon footprint of the second module in the production stage.

By modularly calculating the carbon footprint of the vehicle in the production stage based on the carbon footprint model, the carbon footprint may be comprehensively controlled in the research and development stage and targeted suggestions are put forward on the vehicle design in terms of the carbon footprint.

**Brief Description of the Drawings**

The foregoing and other features of the disclosure will be apparent with reference to the accompany drawings, in which

FIG. 1 is a flowchart of a carbon footprint estimation method according to the disclosure; and
FIG. 2 shows sub-steps of the flowchart according to FIG. 1.

**Detailed Description of Embodiments**

It can be readily understood that according to the technical solution of the disclosure, a person of ordinary skill in the art may propose multiple interchangeable structures and implementations without changing the essential spirit of the disclosure. Therefore, the following specific embodiments and the accompanying drawings are merely exemplary descriptions of the technical solutions of the disclosure, and should not be construed as the entirety of the disclosure or construed as limiting the technical solution of the disclosure.

Directional terms, such as up, down, left, right, front, rear, front side, back side, top, and bottom, which are or may be mentioned in this description, are defined with respect to the structures shown in the accompanying drawing, and are relative concepts, and therefore may correspondingly vary depending on different positions and different conditions in use. Therefore, these or other orientation terms should not be construed as restrictive terms as well. Moreover, the terms such as "first" "second", "third" or similar expressions are only used for description and distinction purposes, and should not be construed as indicating or implying the relative importance of corresponding components.

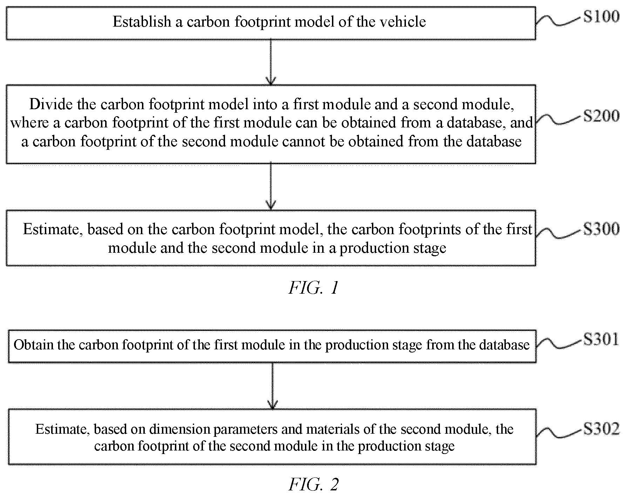

Referring to FIG. 1, FIG. 1 shows a carbon footprint estimation method according to the disclosure. The method can be applied to a battery electric vehicle with a traction battery or a hybrid vehicle, and the traction battery is not limited to a lithium-ion battery, but can also relate to a fuel cell (such as a hydrogen fuel cell), a super capacitor, an aluminum-air cell, or the like. It should be first noted that the disclosure mainly relates to the estimation of a carbon footprint in a production stage, which includes three stages: vehicle body production, parts and components production, and automobile assembly, namely, a whole stage from the collection of raw materials to the completion of manufacturing. In addition, the method can not only be used to estimate the carbon footprint of the vehicle, but also involve the estimation of the carbon footprint of each subsystem of the vehicle.

The method mainly includes the following steps:

S100: establishing a carbon footprint model of the vehicle;
S200: dividing the carbon footprint model into a first module and a second module, wherein a carbon footprint of the first module can be obtained from a database, and a carbon footprint of the second module cannot be obtained from the database; and
S300: estimating, based on the carbon footprint model, the carbon footprints of the first module and the second module in a production stage;
where step S300 includes the following sub-steps:

S301: obtaining the carbon footprint of the first module in the production stage from the database; and
S302: estimating, based on dimension parameters and materials of the second module, the carbon footprint of the second module in the production stage.

It should be noted that the step names mentioned above (and further be mentioned below) are merely used to distinguish between the steps and facilitate reference of the steps, and do not represent a sequence relationship between the steps, and the flowcharts including the drawings are merely examples of performing the method. Without significant conflict, the steps may be performed in various orders or simultaneously.

Therefore, by means of this method, the carbon footprint of the vehicle or components of the vehicle can be quickly estimated based on the carbon footprint model (which is equivalent to a vehicle model) or vehicle selection, so that the carbon footprint of the vehicle can be comprehensively controlled in a research and development stage. In addition, when the carbon footprint cannot meet requirements of corresponding laws and regulations, corresponding parameters of the vehicle can be adjusted in time. Compared with the carbon footprint calculation method based on the vehicle in the prior art, this method reduces product research and development costs to a certain extent.

In step S100, the carbon footprint model or the model of each subsystem of the vehicle can be established based on a CAD (Computer Aided Design), a CAE (Computer Aided Engineering), a SolidWorks, a CATIA (Computer-Aided Three-Dimensional Interactive Application) and other platforms, and can also be expressed as relevant data of the vehicle in a simplest way, namely, size parameters (a wheelbase, a width of the vehicle, volumes of the parts and components, or the like) of the vehicle or parts and components, selection of relevant parts and components (for example, selection of traction batteries, motors, or the like), materials of the relevant parts and components (materials of the body-in-white), or the like. Here, the relevant data of the vehicle can also be integrated in the form of a table, and the table can also be regarded as a carbon footprint model in terms of functions.

Based on the established carbon footprint model, the carbon footprint of the vehicle or the subsystem of the vehicle is estimated in a modular manner, which is implemented in the above steps S200 and S300. Specifically, the carbon footprint of the subsystem or a part of the subsystem is calculated depending on whether the subsystem or the part of the subsystem is a general part or a non-general part. Herein, the concept of "general part" means that its carbon footprint can be directly provided by its manufacturer or corresponding laws and regulations or obtained directly or in a simplest way based on its corresponding parameters, while the "non-general part" means that its carbon footprint cannot be directly provided by the manufacturer or corresponding laws and regulations. In the estimation process, the carbon footprint of the general part (belonging to the first module mentioned above, which can also be referred to as a general module) is directly obtained from a database or based on the corresponding laws and regulations, while the carbon footprint of the non-general part (belonging to the second module mentioned above, which can also be referred to as a non-general module) is estimated based on a method to be further described. Optionally, the first module mentioned above can include but is not mandatory to include a traction battery system, an electric drive system and a seat system, and the second module mentioned above can include but is not mandatory to include a body-in-white system and a chassis system.

The determination of a general part and a non-general part can be modified according to specific configuration of a designed vehicle model. For example, if a supplier has calculated the carbon footprint of the chassis system when providing the chassis system, it can also be classified as the general module.

Specifically, the carbon footprints of the traction battery system, the electric drive system and the seat system in the first module can be read from the database. For example, the carbon footprint of the traction battery in the production stage can be obtained based on energy density, a weight and a type of the traction battery, where the traction battery system includes a traction battery and its corresponding accessories (such as a thermal management system, an electrical system, or the like). The size of the carbon footprint of the traction battery system in the production stage also depends on the applied materials, such as its shell or materials of corresponding positive and negative electrodes. The corresponding data can refer to the published relevant regulations, for example, the Technical Specification for Life Cycle Carbon Emissions Accounting of Passenger Vehicles formulated by China Automotive Technology&Research Center Co. Ltd.

The electric drive system includes a motor (additionally, there are an electric control system, a reduction gearbox, and the like), and the carbon footprint of the motor in the production stage can be directly obtained from the database according to the selection of the motor. The carbon footprint of the motor also depends on the applied materials, for example, the ratio of copper or the ratio of a metal used in its motor shell.

As a general part, the carbon footprint of the seat system can also be obtained from the database or provided directly by the manufacturer. The carbon footprint of the seat system depends on its size, quantity and ratio of each material.

Considering the needs of customers, each vehicle model may have a different geometric dimension, which can be directly reflected in the geometric dimensions of the vehicle body. In a design stage, the carbon footprint of the body-in-white system in the production stage is estimated based on its materials and mass (which further depends on an average bulk density of the body-in-white system and a theoretical volume enclosed by the body-in-white system). Herein, the body-in-white refers to a welded assembly of an unpainted vehicle body structure and covering parts, and includes a front wing, a vehicle door, an engine hood and a trunk lid, but does not include accessories and decorating parts. In addition, the "theoretical volume enclosed by the body-in-white system" is different from an interior space of the vehicle, and refers to the volume enclosed by the body-in-white without assembling other parts and components. Therefore, according to the disclosure, the carbon footprint $CF_1$ of the body-in-white system in the production stage can be calculated based on the following formula:

$$CF_1 = \rho \times V \times a$$

where $\rho$ is the average bulk density of the body-in-white system;

V is the theoretical volume enclosed by the body-in-white system; and

a is a constant, depending on the material of the body-in-white system and its corresponding material ratio.

Herein, the above average bulk density can be determined according to the vehicle model (SUV (Sport Utility Vehicle), Sedan or Hatchback) and the material of the body-in-white. In an embodiment, the average bulk density can be selected based on a bulk density stored in the database. For example, when the vehicle is an SUV with an aluminum vehicle body, the average bulk density of the body-in-white system in a same type of vehicles in the database is obtained, which improves the accuracy of estimating the carbon footprint of the body-in-white system to some extent.

Optionally, considering the irregular shape of the vehicle, the body-in-white can be divided into several sub-sections according to the front axle and rear axle of the vehicle and the theoretical volume enclosed by the body-in-white can be calculated in modules. For example, the vehicle is divided into the following three sub-sections in a longitudinal direction (axial direction): a first sub-section (from front of the vehicle body to the front axle), a second sub-section (from the front axle to the rear axle), and a third sub-section (from the rear axle to rear of the vehicle body).

According to the disclosure, the theoretical volume is divided and simplified into a plurality of regular cubes based on the front and rear axles of the vehicle, which can also be implemented in consideration of a specific model of the vehicle. For example, in the case of an SUV, the ratio of the heights of the first sub-section and the second sub-section to the height of the second sub-section (the height of the vehicle body) is 0.665. In the case of a Sedan vehicle, the ratio of the heights of the first sub-section and the second sub-section to the height of the second sub-section (the height of the vehicle body) is 0.5.

It should be noted that the division of the vehicle body is not limited to the scheme based on the front and rear axles mentioned above, and can be specifically modified according to the shape of the vehicle body. In addition, the calculation of the volume enclosed by each sub-section is not limited to the method mentioned above, and it can also be implemented by any mathematical method such as calculus.

In addition, the parameter a for calculating the carbon footprint of the body-in-white system depends on the used materials and the ratio of each material, which can be expressed by the following formula:

$$a = \sum_{i=1}^{n} w_i \cdot k_i$$

where n is a quantity of material types of the body-in-white system;
$w_i$ is a ratio of each material; and
$k_i$ is a carbon emission factor of each material.

For example, when the body-in-white system is made of steel or aluminum alloy, it can be expressed as: $a = w_1 \cdot k_1 + (1 - w_1) \cdot k_2$ where $w_1$ is the ratio of steel; $k_1$ is the carbon emission factor of steel, its value range is (0, 5], and its unit is kgCO$_2$e/kg; $k_2$ is the carbon emission factor of aluminum alloy, its value range is, for example, (0, 40], and its unit is kgCO$_2$e/kg, where "kgCO$_2$e" indicates carbon dioxide equivalent per kilogram. The carbon dioxide equivalent refers to a measurement unit for comparing the emissions of different greenhouse gases, and the contribution of different greenhouse gases to the global greenhouse effect is different. To measure the overall greenhouse effect uniformly, because carbon dioxide is the main gas produced by human activities, it is stipulated that the carbon dioxide equivalent is the basic unit to measure the greenhouse effect.

Regarding the chassis system of the second module, it should be noted that the chassis systems of the battery electric vehicle and the hybrid vehicle are different from those of traditional internal combustion engine vehicles, which omit relevant transmission components. Therefore, the carbon footprint of the chassis system in the production stage largely depends on the geometric dimensions of the vehicle, for example, depending on the wheelbase and/or the width of the vehicle. Optionally, the carbon footprint CF$_2$ of the chassis system in the production stage can be calculated according to the wheelbase of the vehicle, that is:

$$CF_2 = L \times b$$

where L is the wheelbase of the vehicle;
b is a constant, which depends on the wheelbase of the vehicle, its value range is, for example, 0.5 to 25, and its unit is kgCO$_2$e/m.

Optionally, the second module also includes an accessory system, including interior trim parts (for example, an instrument panel, a sub-instrument panel, a door panel, an inside door handle, a pillar interior trim panel, a carpet, a roof lining, a sun shield, or the like), exterior trim parts (for example, a bumper, an air-inlet grille, a rearview mirror, a car lamp, a pillar trim panel, a luggage rack, a door handle, a sunroof, a wiper, or the like), electronic devices, air conditioners, radars, cameras, and the like. The carbon footprint of the accessory system in the production stage is related to the volume of the vehicle, that is, the theoretical volume enclosed by the body-in-white system. For example, the carbon footprint CF$_3$ of the accessory system can be calculated based on the above simplified theoretical volume, that is:

$$CF_3 = V \times c$$

where V is the theoretical volume enclosed by the body-in-white system; and

c is constant, its value range is, for example, 0.5 to 25, and its unit is kgCO$_2$e/(m$^3$).

It should be noted that the above calculation methods and corresponding numerical ranges for each subsystem of the vehicle are not limited to the ranges given above, which can be appropriately adjusted according to specific vehicle models and vehicle parameters.

In addition, according to another aspect of the disclosure, a system for implementing the carbon footprint estimation method described above includes:

an input device, configured to input vehicle parameters;

a model generation device, connected to the input device and configured to establish a carbon footprint model based on the input vehicle parameters, where the carbon footprint model includes a first module and a second module, a carbon footprint of the first module can be obtained from a database, and a carbon footprint of the second module cannot be obtained from the database;

a memory, storing the carbon footprint of the first module in a production stage; and

an estimation device, connected to the memory and configured to obtain, from the memory, the carbon footprint of the first module in the production stage and to estimate, based on dimension parameters and materials of the second module, the carbon footprint of the second module in the production stage.

Herein, the input device can be set as, for example, a screen or a corresponding controller, through which the user can input relevant parameters or model selection of the vehicle. In addition, the input device set as a screen can also be used as an output device for displaying the estimated carbon footprint of the vehicle and/or the related data of the vehicle in a form of graphs or characters.

In conclusion, by modularly calculating the carbon footprint of the vehicle or its subsystems in the production stage depending on whether it belongs to the general parts or the non-general parts and based on the vehicle parameters or the carbon footprint model, the carbon footprint may be comprehensively controlled in the research and development stage and targeted suggestions are put forward on the vehicle design in terms of the carbon footprint.

It should be understood that all of the above preferred embodiments are exemplary rather than limiting, and any modification or variation made by those skilled in the art to the specific embodiments described above without departing from the concept of the disclosure shall fall within the scope of legal protection of the disclosure.

**Claims**

1. A carbon footprint estimation method for a vehicle, comprising the following steps:

S100: establishing a carbon footprint model of the vehicle;

S200: dividing the carbon footprint model into a first module and a second module, wherein a carbon footprint of the first module can be obtained from a database, and a carbon footprint of the second module cannot be obtained from the database; and

S300: estimating, based on the carbon footprint model, the carbon footprints of the first module and the second module in a production stage; wherein step S300 comprises the following sub-steps:

S301: obtaining the carbon footprint of the first module in the production stage from the database; and

S302: estimating, based on dimension parameters and materials of the second module, the carbon footprint of the second module in the production stage.

2. The carbon footprint estimation method according to claim 1, wherein the first module comprises a traction battery system, an electric drive system and a seat system, and/or the second module comprises a body-in-white system and a chassis system.

3. The carbon footprint estimation method according to claim 2, wherein in step S302, depending on materials of the body-in-white system, a carbon footprint of the body-in-white system in the production stage is estimated based on an average bulk density of the body-in-white system and a theoretical volume enclosed by the body-in-white system.

4. The carbon footprint estimation method according to claim 3, wherein the average bulk density depends on a vehicle model and a ratio of materials for manufacturing the body-in-white system.

5. The carbon footprint estimation method according to claim 4, wherein in step S302, the body-in-white system is divided based on a front axle and a rear axle of the carbon footprint model, and the theoretical volume enclosed by the body-in-white system is estimated in modules.

6. The carbon footprint estimation method according to claim 5, wherein the body-in-white system is divided into a plurality of cubes based on the front axle and the rear axle of the carbon footprint model, and theoretical volumes of the cubes are calculated respectively.

7. The carbon footprint estimation method according to any one of claims 2 to 6, wherein in step S302, a carbon footprint of the chassis system in the production stage is estimated based on a wheelbase of the carbon footprint model.

8. The carbon footprint estimation method according to any one of claims 2 to 6, wherein in step S301, a carbon footprint of the traction battery system in the production stage is obtained from the database based on materials, energy density and mass of the traction battery system in the carbon footprint model.

9. The carbon footprint estimation method according to any one of claims 1 to 6, wherein the second module further comprises an accessory system, comprising interior trim parts, and a carbon footprint of the accessory system in the production stage is estimated according to the dimension parameters of the second module.

10. A carbon footprint estimation system for a vehicle, configured to implement the carbon footprint estimation method according to any one of claims 1 to 9, comprising:

an input device, configured to input vehicle parameters;
a model generation device, connected to the input device and configured to establish a carbon footprint model based on the input vehicle parameters, wherein the carbon footprint model comprises a first module and a second module, a carbon footprint of the first module can be obtained from a database, and a carbon footprint of the second module cannot be obtained from the database;
a memory, storing the carbon footprint of the first module in a production stage; and
an estimation device, connected to the memory and configured to obtain, from the memory, the carbon footprint of the first module in the production stage and to estimate, based on dimension parameters and materials of the second module, the carbon footprint of the second module in the production stage.

Establish a carbon footprint model of the vehicle ⌇ S100

↓

Divide the carbon footprint model into a first module and a second module, where a carbon footprint of the first module can be obtained from a database, and a carbon footprint of the second module cannot be obtained from the database ⌇ S200

↓

Estimate, based on the carbon footprint model, the carbon footprints of the first module and the second module in a production stage ⌇ S300

*FIG. 1*

Obtain the carbon footprint of the first module in the production stage from the database ⌇ S301

↓

Estimate, based on dimension parameters and materials of the second module, the carbon footprint of the second module in the production stage ⌇ S302

*FIG. 2*

Europäisches
Patentamt

European
Patent Office

Office européen
des brevets

# EUROPEAN SEARCH REPORT

Application Number

**EP 23 15 1048**

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | Contreras Ordonez Emmanuel: "Product Carbon Footprint of a Conventional Vehicle", , 7 August 2018 (2018-08-07), pages 1-87, XP093044882, Karlsruhe Retrieved from the Internet: URL:https://ri.itba.edu.ar/server/api/core /bitstreams/9b50847c-529c-483d-b629-190412 418284/content [retrieved on 2023-05-08] * Section 3.1.1. * ----- | 1-10 | INV. G06Q10/04 G06Q50/04 |

TECHNICAL FIELDS
SEARCHED (IPC)

G06Q

The present search report has been drawn up for all claims

| Place of search | Date of completion of the search | Examiner |
|---|---|---|
| Munich | 12 May 2023 | Gabriel, Christiaan |

EPO FORM 1503 03.82 (P04C01)